# EUROPEAN PATENT APPLICATION

(11) **EP 4 726 416 A1**
(43) Date of publication of application: **15.04.2026**
(21) Application number: 24894450.6
(22) Date of filing: 04.11.2024
(51) Int. Cl.: G01R 31/392, G01R 31/52, G01R 31/396, G01R 31/367, G01R 31/382, G01R 19/165

(54) **BATTERY DIAGNOSIS APPARATUS AND METHOD**

(30) Priority: 20.11.2023 KR 20230160137
(71) Applicant: LG Energy Solution, Ltd., Seoul 07335 (KR)
(72) Inventor: KIM, Hak In, Daejeon 34122 (KR)
(74) Representative: Plasseraud IP
(86) International application number: PCT/KR2024/017106
(87) International publication number: WO 2025/110556

(57) **Abstract**

A battery diagnosis apparatus according to one embodiment of the present invention is an apparatus for diagnosing the state of a battery pack including a plurality of cells, and may comprise: at least one processor; and a memory for storing at least one command executed through the at least one processor, wherein the at least one command can include the commands of: checking whether the battery pack enters a rest state after being fully charged; measuring a first voltage after a first time elapses after entering the rest state; measuring a second voltage after a second time elapses after entering the rest state; calculating a self-discharge amount of the battery pack on the basis of the first voltage and the second voltage; and determining the state of the battery pack by comparing the self-discharge amount of the battery pack to a preset threshold discharge current amount.

## Description

### CROSS-REFERENCE TO RELATED APPLICATION

This application is a National Phase entry pursuant to 35 U.S.C. 371 of International Application PCT/KR2024/017106 filed on November 4, 2024, which claims priority to and the benefit of Korean Patent Application No.10-2023-0160137 filed in the Korean Intellectual Property Office on November 20, 2023, the entire contents of which are incorporated herein by reference.

### TECHNICAL FIELD

The present disclosure relates to a battery diagnosis apparatus and method, and more particularly, to a battery diagnosis apparatus and method for diagnosing short-curcuit in a battery using self-discharge amount of the battery.

### BACKGROUND

Secondary batteries, capable of recharging and reuse, may be used as an energy source for small devices such as mobile phones, tablet PCs and vacuum cleaners, and also used as an energy source for medium and large devices such as personal mobility, automobiles and an energy storage system (ESS) for smart grids.

Secondary batteries may be applied to a system in a form of an assembly such as a battery module or battery pack in which a plurality of battery cells is connected in series and parallel or a battery rack in which battery modules or battery packs are connected in series and parallel according to system requirements.

Secondary batteries are manufactured to prevent short circuits by preventing contact between positive and negative electrodes through a porous insulating film (separator), but during the battery manufacturing process, insulation may not be properly maintained due to various reasons, which may cause internal short circuits (shorts) in the battery. If the positive and negative electrodes of a lithium-ion battery are short circuited, it may lead to ignition or explosion, and even if the short circuit is very small, ions move and current flows a stat of which is commonly called a soft short or micro short. If precipitates are generated due to the soft short, low-voltage failures may occur.

During the manufacturing process, battery cells may undergo stability tests such as over-current tests, high-temperature storage tests, short circuit tests, and penetration tests to evaluate safety of the battery due to defects or failures that may occur during the operation of the battery. However, even in batteries that have passed these stability tests and have been shipped, defects that were not detected during the shipping tests may still remain, or problems such as low current and short circuits may occur during battery use due to factors such as the operating environment, which may pose a risk to the safety of the battery pack.

The background description provided herein is for the purpose of generally presenting context of the disclosure. Unless otherwise indicated herein, the materials described in this section are not prior art to the claims in this application and are not admitted to be prior art, or suggestions of the prior art, by inclusion in this section.

### SUMMARY

To obviate one or more problems of the related art, embodiments of the present disclosure provide a battery diagnosis apparatus for diagnosing a low voltage or short-circuit condition of a cell in a battery pack.

To obviate one or more problems of the related art, embodiments of the present disclosure also provide a battery diagnosing method for diagnosing a low voltage or short-circuit condition of a cell in a battery pack.

In order to achieve the objective of the present disclosure, a battery diagnosis apparatus, for diagnosing state of a battery pack including a plurality of cells, may include at least one processor and a memory configured to store at least one instruction executed by the at least one processor.

Here, the at least one instruction may include an instruction to monitor whether the battery pack has entered a rest state after being fully charged; an instruction to measure a first voltage after a first time period has elapsed after entering the rest state; an instruction to measure a second voltage after a second time period has elapsed after entering the rest state; an instruction to calculate a self-discharge amount of the battery pack based on the first voltage and the second voltage; and an instruction to determine the state of the battery pack by comparing the self-discharge amount of the battery pack with a predetermined threshold amount of discharge current.

Here, the instruction to calculate a self-discharge amount of the battery pack may include an instruction to derive a first SOC matching the first voltage and a second SOC matching the second voltage using an state of charge (SOC)-voltage correlation; and an instruction to calculate a self-discharge amount using difference between the first SOC and the second SOC.

The first voltage and the second voltage may be obtained by measuring open circuit voltages (OCV) of the battery pack.

The instruction to determine the state of the battery pack may include an instruction to determine that an abnormality has occurred in at least one of the plurality of battery cells if the self-discharge amount of the battery pack is greater than or equal to the predetermined threshold amount of discharge current.

Here, whether the first time has elapsed and whether the second time has elapsed may be determined using a real time clock (RTC) inside a battery management system (BMS).

Meanwhile, the threshold amount of discharge current may indicate an amount of self-discharge current that occurs when an internal short circuit occurs in a battery cell and may be obtained in advance through an experiment on a battery cell in which an internal short circuit occurs.

Here, the threshold amount of discharge current may include a first threshold amount of discharge current that indicates that a permanent failure has occurred in the battery pack; a second threshold amount of discharge current that indicates that a repairable fault has occurred in the battery pack; and a third threshold amount of discharge current that indicates that a minor abnormality compared to the repairable fault has occurred in the battery pack.

According to another embodiment of the present disclosure, a method for diagnosing state of a battery pack including a plurality of cells may include monitoring whether the battery pack has entered a rest state after being fully charged; measuring a first voltage after a first time period has elapsed after entering the rest state; measure a second voltage after a second time period has elapsed after entering the rest state; calculating a self-discharge amount of the battery pack based on the first voltage and the second voltage; and determining the state of the battery pack by comparing the self-discharge amount of the battery pack with a predetermined threshold amount of discharge current.

The calculating the self-discharge amount of the battery pack may include deriving a first SOC matching the first voltage and a second SOC matching the second voltage using an state of charge (SOC)-voltage correlation; and calculating a self-discharge amount using difference between the first SOC and the second SOC.

The first voltage and the second voltage may be obtained by measuring open circuit voltages (OCV) of the battery pack.

The determining the state of the battery pack may include determining that an abnormality has occurred in at least one of the plurality of battery cells if the self-discharge amount of the battery pack is greater than or equal to the predetermined threshold amount of discharge current.

Here, whether the first time has elapsed and whether the second time has elapsed may be determined using a real time clock (RTC) inside a battery management system (BMS).

Meanwhile, the threshold amount of discharge current may indicate an amount of self-discharge current that occurs when an internal short circuit occurs in a battery cell and may be obtained in advance through an experiment on a battery cell in which an internal short circuit occurs.

Here, the threshold amount of discharge current may include a first threshold amount of discharge current that indicates that a permanent failure has occurred in the battery pack; a second threshold amount of discharge current that indicates that a repairable fault has occurred in the battery pack; and a third threshold amount of discharge current that indicates that a minor abnormality compared to the repairable fault has occurred in the battery pack.

According to embodiments of the present disclosure, it is possible to diagnose an abnormality caused by a short circuit in a battery cell within a short period of time without using the battery for a long period of time.

Accordingly, the safety of battery pack can be enhanced through a more robust battery pack condition diagnosis.

### BRIEF DESCRIPTION OF THE DRAWINGS

FIG. 1 is a block diagram of a battery system to which embodiments of the present disclosure may be applied.
FIG. 2 is a schematic flowchart of a typical method for detecting a cell internal short circuit in a battery system.
FIG. 3 is an operational flowchart of a battery diagnosing method according to embodiments of the present disclosure.
FIG. 4 is a graph showing the SOC-voltage correlation used for calculating self-discharge amount according to embodiments of the present disclosure.
Fig. 5a is a graph showing a result of a self-discharge current measurement experiment when a short circuit occurs inside a cell. Fig. 5b is a graph showing a result of a voltage measurement experiment when a short circuit occurs inside a cell.
FIG. 6 is a detailed operational flowchart of processing battery diagnosis based on self-discharge amount according to embodiments of the present disclosure.
FIG. 7 is a block diagram of a battery diagnosis apparatus according to embodiments of the present disclosure.

100: battery
200: battery diagnosis apparatus
210: processor
220: memory
230: communication module
290: RTC element

### DETAILED DESCRIPTION

The present disclosure may be modified in various forms and have various embodiments, and specific embodiments thereof are shown by way of example in the drawings and will be described in detail below. It should be understood, however, that there is no intent to limit the present disclosure to the specific embodiments, but on the contrary, the present disclosure is to cover all modifications, equivalents, and alternatives falling within the spirit and technical scope of the present disclosure. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes combinations of a plurality of associated listed items or any of the plurality of associated listed items.

It will be understood that when an element is referred to as being "coupled" or "connected" to another element, it may be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present disclosure. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present disclosure belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells are electrically connected.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present disclosure is not limited to these entities.

State of Charge (SOC) refers to a current state of charge of a battery, represented in percent points [%], and State of Health (SOH) may be a current condition of a battery compared to its ideal or original conditions, represented in percent points [%].

Hereinafter, exemplary embodiments of the present disclosure will be described in detail with reference to the accompanying drawings.

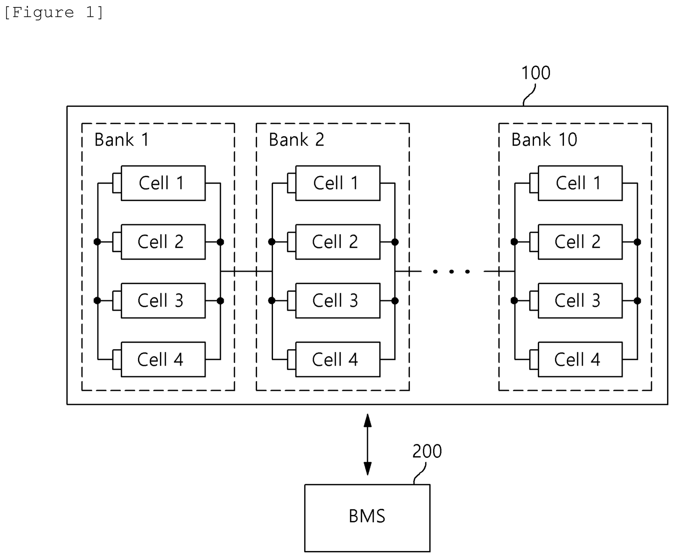

FIG.1 is a block diagram of a battery system to which embodiments of the present disclosure may be applied.

Referring to FIG. 1, a battery pack 100 may include a plurality of battery cells connected in series. More specifically, a plurality of battery cells may be connected in parallel to form a battery bank, and a plurality of battery banks may be connected in series to form a battery pack. In other words, the battery pack 100 may be configured to include a plurality of battery banks including a plurality of battery cells connected in parallel. In the embodiment of FIG. 1, one battery bank includes four battery cells connected in parallel. In addition, one battery pack may include ten battery banks connected in series. However, the number of battery cells constituting the battery bank and the number of battery banks constituting the battery pack are not limited to the embodiment presented in FIG. 1, and the present disclosure may be applied to a battery pack configured with various connection types and various numbers of cells and banks.

Meanwhile, the battery pack may also be referred to as a battery module depending on a system to which the battery pack is applied. In addition, the battery pack may be understood as any term that means an assembly of battery cells that are applied to a specific system or device and function as a power supply source.

The battery pack may be connected to a load through a positive terminal and a negative terminal to perform charging/discharging. A battery management system (BMS) 200 may be installed in such a battery pack. In this specification, a battery system is used as a concept including one or more battery packs 100 and a battery management system 200. In addition, the battery management system 200 may be included inside the battery pack 100 and the battery pack may be used in the same/similar sense as the battery system.

The battery management system (BMS) 200 may monitor current, voltage, and temperature of the battery pack, calculate a state of charge (SOC) based on monitoring results, and control charging/discharging. Here, the state of charge (SOC) is presented as a ratio [%] of the current charged state of the battery.

The battery management system (BMS) 200 may also evenly balance the charge among battery cells or among battery banks in order to extend the life of the battery system. To perform such operations, the BMS 200 may include various components such as a fuse, a current sensing element, a thermistor, a switch, and a balancer.

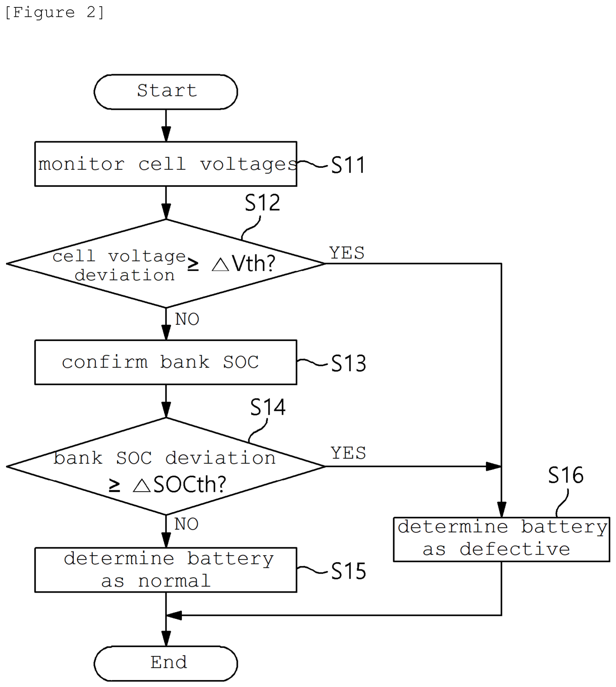

FIG. 2 is a schematic flowchart of a typical method for detecting a cell internal short circuit in a battery system.

A battery management system may generally detect an internal short circuit in a cell by detecting voltage deviation and SOC deviation among banks. Fig. 2 illustrates a typical method for determining an internal short circuit in a cell using a bank imbalance diagnosis function of the BMS.

Referring to Fig. 2, the BMS measures a voltage of each cell in the battery pack and monitors the voltage deviation among cells (S11). Here, in the battery system as shown in Fig. 1, the voltage of each measured cell is the same as the voltage of the corresponding bank since four battery cells included in one bank are connected in parallel. Therefore, in the battery system as shown in Fig. 1, the voltage deviation among cells may be used in the same meaning as the voltage deviation among banks. The voltage deviation among cells may be measured when the battery is being charged, discharged, and in a rest state, respectively.

The measured cell-to-cell voltage deviation is compared with a threshold voltage deviation (△Vth) (S12), and if the cell-to-cell voltage deviation is equal to or greater than the threshold voltage difference, it is determined that a defect has occurred in the battery (S16) and a warning signal is generated. Here, the threshold voltage deviation (△Vth) may be set to, for example, 100 mV. In response to the generated warning signal, the BMS may control a charge field effect transistor (FET) or a discharge FET operating in a corresponding mode.

The BMS monitors the cell-to-cell voltage deviation as well as the SOC of each bank and compares the SOC of each bank (S13). The SOC deviation among banks is compared with a threshold SOC deviation △SOCth (S14). If the SOC deviation among banks is greater than or equal to the threshold SOC deviation △SOCth, the battery pack is determined to be a defective or faulty battery ((S16). Here, the threshold SOC deviation △SOCth that may be determined to be a fault may be set to, for example, 20%. In addition, the threshold SOC deviation (△SOCth) that may be determined to be a fault to the extent of generating a warning signal may be set to, for example, 10%. If the battery is determined to be faulty, the BMS may turn off both the charge FET and the discharge FET and stop the charging and discharging operation. In addition, if the battery is determined to be defective, the BMS may generate a warning signal and control the charge FET or the discharge FET operating in the corresponding mode in response to the generated warning signal.

Meanwhile, if the voltage deviation among cells is less than the threshold voltage deviation and the SOC deviation among banks is less than the threshold SOC deviation (△SOCth), the battery pack is determined to be normal (S15).

However, a method of detecting a short circuit within a battery cell illustrated in Fig. 2 has a problem in that it cannot quickly diagnose defects or faults within the battery pack, as it is provided at a level where detection of imbalance among cells or among banks is possible only when the battery pack is stored for a long period of time and the battery pack is actually used.

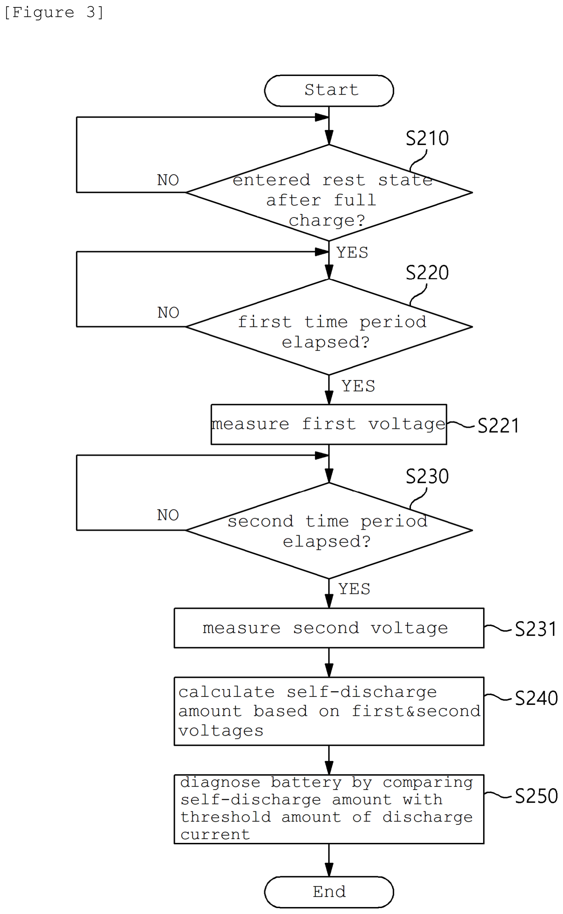

FIG. 3 is an operational flowchart of a battery diagnosing method according to embodiments of the present disclosure.

The battery diagnosis method according to embodiments of the present disclosure may be performed by a battery diagnosis apparatus. The battery diagnosis apparatus according to embodiments of the present disclosure may be a battery management system (BMS) or may be included as a part of a battery management system.

Referring to FIG. 3, in the battery diagnosis method according to embodiments of the present disclosure, first, it is monitored whether a battery pack including a plurality of cells has reached full charge and whether the battery pack has entered a rest (REST) state after full charge (S210). Additionally, for battery diagnosis according to the present disclosure, it is preferable that the conditions of the SOC of the battery pack being 95% or higher and the temperature being ±25°C are satisfied.

The battery diagnosis apparatus may determine whether a first time period has passed after the battery pack has entered the rest (REST) state (S220), and measure a first voltage at the time point when the first time period has elapsed (S221). Thereafter, the battery diagnosis apparatus may confirm whether a second time period has elapsed after the battery pack has entered the rest (REST) state (S230), and measure a second voltage at the time point when the second time period has elapsed (S231). Here, the second time period may be set to a longer time than the first time period, for example, the first time may be set to 2 hours and the second time period may be set to 6 hours. Here, the voltage may be measured as an open circuit voltage (OCV) of the battery pack.

Meanwhile, when the battery enters a rest state, the BMS may limit or terminate operations of devices or components in the BMS associated with unnecessary operations depending on the state of the battery. However, the real time clock (RTC) may operate even when the BMS is in, for example, a low-power mode. The RTC (Real Time Clock) is a circuit that is always powered and turned on regardless of whether the BMS is operating or not. The RTC has a program that internally calculates time and may be used by setting initial values, alarm cycles, etc. In embodiments of the present disclosure, the elapsed time of the first time period and the elapsed time of the second time period may be confirmed by using function of the RTC.

The battery diagnosis apparatus may calculate self-discharge amount of the battery pack based on a first voltage and a second voltage measured in this manner (S240). Here, the self-discharge amount of the battery pack may be calculated by deriving a first SOC matching the first voltage and a second SOC corresponding to the second voltage using the SOC-voltage correlation graph and using the difference between the first SOC and the second SOC.

Thereafter, the battery diagnosis apparatus may determine the state of the battery pack by comparing the self-discharge amount of the battery pack with a predefined threshold amount of discharge current (S250). Here, the predefined threshold amount of discharge current may represent amount of self-discharge current that occurs when the battery cell is short-circuited internally.

Meanwhile, the threshold discharge current amount may be classified as a first threshold amount of discharge current indicating that a permanent failure has occurred in the battery pack, a second threshold amount of discharge current indicating that a repairable fault has occurred in the battery pack, and a third threshold amount of discharge current indicating that a minor abnormality has occurred in the battery pack that is less than a repairable fault. Here, the minor abnormality associated with the third threshold amount of discharge current may include a case where the battery cell is in a low voltage state but not in a short-circuited state.

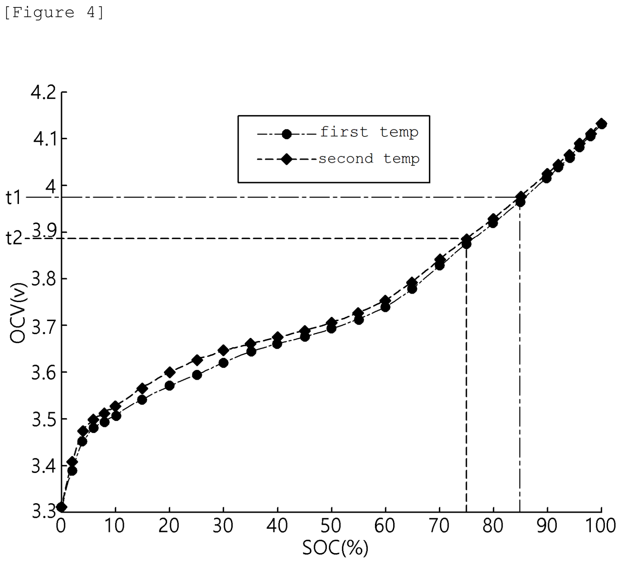

FIG. 4 is a graph showing the SOC-voltage correlation used for calculating self-discharge amount according to embodiments of the present disclosure.

In the graph of FIG. 4, the horizontal axis represents the SOC (%) of the battery pack and the vertical axis represents the Open Circuit Voltage (OCV) of the battery pack. As shown in FIG. 4, the SOC-voltage correlation may vary depending on the temperature (the graphs according to a first temperature and a second temperature in FIG. 4 are different), and it is appropriate that the temperature is maintained at about ±25°C during the diagnosis as a desirable condition for the battery diagnosis according to embodiments of the present disclosure.

As described above, the OCV of the battery pack may be measured at a first time point (t1) after a first time period has elapsed since the battery pack is fully charged and the voltage value at the first time point (t1) may be obtained. Here, a first SOC corresponding to the first voltage value measured at the first time point (t1) may be derived through the SOC-voltage correlation graph.

In addition, an OCV of the battery pack may be measured at a second time point (t2) after a second time has elapsed since the battery pack is fully charged and the voltage value at the second time point (t2) may be obtained. Here, a second SOC corresponding to the second voltage value measured at the second time point (t2) may be derived through the SOC-voltage correlation graph.

Thereafter, difference between the first SOC and the second SOC may be calculated and self-discharge amount of the battery pack may be calculated from the difference between the first SOC and the second SOC and the nominal capacity of the battery pack. Here, the nominal capacity may mean a determined capacity [Ah] of the battery set by a battery manufacturer during development.

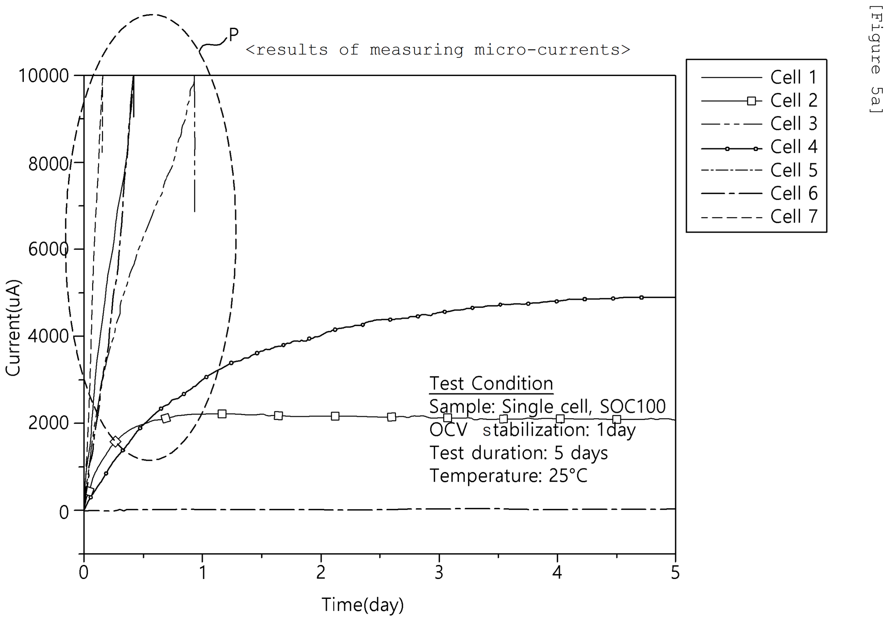

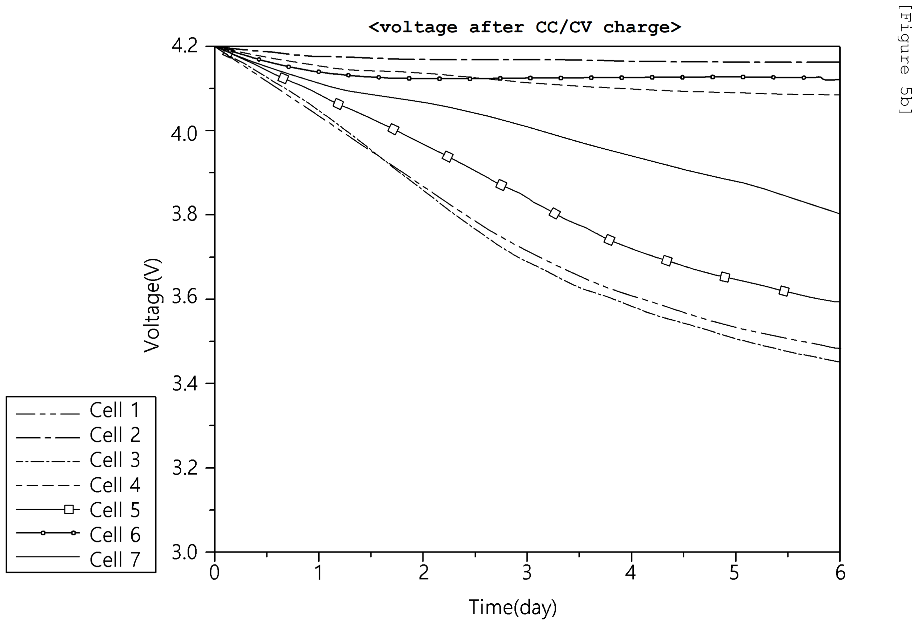

Fig. 5a is a graph showing a result of a self-discharge current measurement experiment when a short circuit occurs inside a cell. Fig. 5b is a graph showing a result of a voltage measurement experiment when a short circuit occurs inside a cell.

The results of the self-discharge current measurement experiment when a short circuit occurs inside a cell, as shown in Fig. 5a, may be used to derive a threshold current amount according to embodiments of the present disclosure.

As experimental conditions, the experiment was performed on various sample cells with SOC 100% (including samples with a short circuit inside the cell), the temperature during the experiment was 25°C, and the period of experiment was 5 days in total. Here, constant current (CC) /constant voltage (CV) charge method was used to reach a full charge of SOC 100%.

The experiment shows results of measuring micro-current flowing in the sample cells in various states. It may be understood that while there are sample cells in which the amount of current hardly changes over the entire 5-day experimental period, there are also sample cells in which micro-current increases significantly in less than a day. Among these, in the case of sample cells (P region of Fig. 5a) in which shows a very large increase of micro-current, it may be understood that the cell has a short circuit inside the cell. Depending on a degree of micro-current generation, the corresponding cells may be classified as cells with an abnormality, cells with a fault (repairable), or cells with a permanent failure.

Meanwhile, Fig. 5b shows a result of measuring a voltage change over a 5-day experimental period in an experiment under the same conditions as Fig. 5a. It may be confirmed that voltage decrease is large in the case of cells where a short circuit occurs inside the cell and a large current self-discharge current occurs.

In the present disclosure, the results of the self-discharge current measurement experiment when a short circuit occurs inside the cell are determined as the threshold discharge current amount according to embodiments of the present disclosure and utilized.

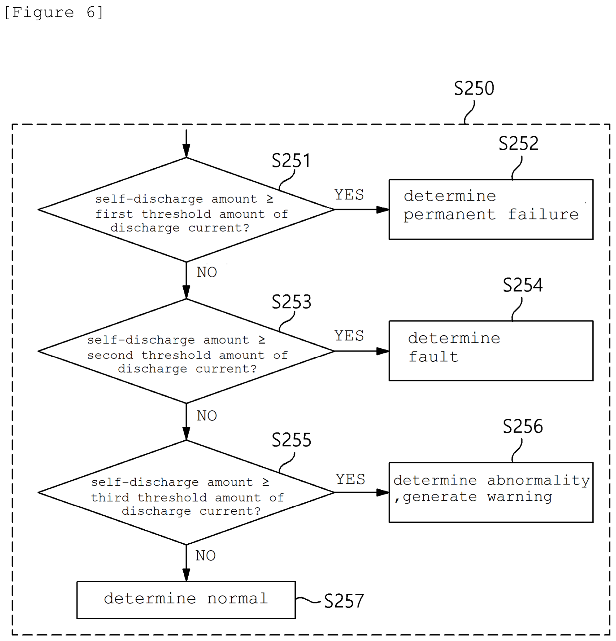

FIG. 6 is a detailed operational flowchart of processing battery diagnosis based on self-discharge amount according to embodiments of the present disclosure.

In FIG. 6, among the entire operations of the battery diagnosis method according to the present disclosure explained through FIG. 4, a detailed operation of step S250 which compares the self-discharge amount of the battery pack to the predefined threshold discharge current amount to determine the state of the battery pack is described.

Upon the self-discharge amount of the battery pack being calculated, the battery diagnosis apparatus may compare the calculated self-discharge amount to a first threshold amount of discharge current (S251). Here, the first threshold amount of discharge current is a value corresponding to a current amount indicating when a permanent failure occurs in the battery pack. The first threshold amount of discharge current may be set to, for example, 10 mAh. If the self-discharge amount of the battery pack is greater than the first threshold amount of discharge current, it is determined that a permanent failure has occurred in the corresponding battery pack (S252). Here, the permanent failure may be understood as an irreparable defect or failure. In the event of a permanent failure, the BMS may control the charge FET and the discharge FET to OFF.

If the self-discharge amount of the battery pack is less than the first threshold discharge current amount, the self-discharge amount is compared with the second threshold amount of discharge current (S253). Here, the second threshold amount of discharge current is a value corresponding to a current amount indicating that a repairable fault occurs in the battery pack. The second threshold amount of discharge current may be set to, for example, 5 mAh. If the self-discharge amount of the battery pack is greater than or equal to the second critical discharge current amount, it may be determined that a fault has occurred in the battery pack (S254). If a fault has occurred in the battery pack, the BMS may control the charge FET and the discharge FET to OFF.

In addition, if the self-discharge amount of the battery pack is less than the second critical discharge current, the self-discharge amount is compared with the third threshold amount of discharge current (S255). Here, the third threshold amount of discharge current is a value corresponding to a current amount indicating that an abnormality occurs in the battery pack. Here, the abnormality associated with the third threshold amount of discharge current may include a case where the battery cell is not in a short-circuited state but is in a low voltage state. The third threshold amount of discharge current may be set to, for example, 3 mAh.

If the self-discharge amount of the battery pack is greater than or equal to the third threshold amount of discharge current, it may be determined that an abnormality has occurred in the battery pack and a warning signal may be generated (S256). On the other hand, if the self-discharge amount of the battery pack is less than the third threshold amount of discharge current, the battery pack may be determined to be normal (S257).

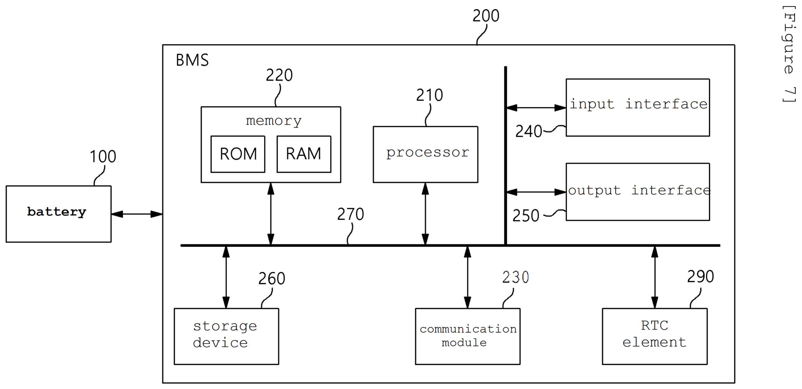

FIG. 7 is a block diagram of a battery diagnosis apparatus according to embodiments of the present disclosure.

Referring to FIG. 7, a battery diagnosis apparatus 200 according to embodiments of the present disclosure may be connected to a battery 100 including a plurality of cells, and may include at least one processor 210, a memory 220 storing at least one command executed through the processor, a communication unit 230 performing data transmission and reception, and an RTC element 290. Here, the battery diagnosis apparatus 200 according to embodiments of the present disclosure may be a battery management system (BMS) or may be included as a part of a battery management system. Here, the battery 100 may be understood as a battery pack, a battery module, or a battery assembly, and may be substituted with any term that may mean a collection of battery cells which are applied to a specific system or device and function as a power supply source.

Here, the at least one processor 210 may be referred to as a control unit, a controller, an micro controller unit (MCU), etc., and may include a central processing unit (CPU), a graphics processing unit (GPU), or a dedicated processor on which methods according to embodiments of the present disclosure are performed.

The RTC element 290 is a circuit that is always powered on and turned on regardless of whether the BMS is operating, and may provide information on the initial time and the passage of time to the processor 210. Accordingly, the processor 210 may determine whether the first time period has elapsed and the second time period has elapsed since the battery enters a rest state, and may measure voltages of the battery pack at these time points.

Here, the processor 210 may execute at least one instruction stored in the memory 220 and the at least one instruction may include an instruction to monitor whether the battery pack has entered a rest state after being fully charged; an instruction to measure a first voltage after a first time period has elapsed after entering the rest state; an instruction to measure a second voltage after a second time period has elapsed after entering the rest state; an instruction to calculate a self-discharge amount of the battery pack based on the first voltage and the second voltage; and an instruction to determine the state of the battery pack by comparing the self-discharge amount of the battery pack with a predetermined threshold amount of discharge current.

Here, the instruction to calculate a self-discharge amount of the battery pack may include an instruction to derive a first SOC matching the first voltage and a second SOC matching the second voltage using an state of charge (SOC)-voltage correlation; and an instruction to calculate a self-discharge amount using difference between the first SOC and the second SOC.

The first voltage and the second voltage may be obtained by measuring open circuit voltages (OCV) of the battery pack.

The instruction to determine the state of the battery pack may include an instruction to determine that an abnormality has occurred in at least one of the plurality of battery cells if the self-discharge amount of the battery pack is greater than or equal to the predetermined threshold amount of discharge current.

Here, whether the first time has elapsed and whether the second time has elapsed may be determined using a real time clock (RTC) inside a battery management system (BMS).

Meanwhile, the threshold amount of discharge current may indicate an amount of self-discharge current that occurs when an internal short circuit occurs in a battery cell and may be obtained in advance through an experiment on a battery cell in which an internal short circuit occurs.

Here, the threshold amount of discharge current may include a first threshold amount of discharge current that indicates that a permanent failure has occurred in the battery pack; a second threshold amount of discharge current that indicates that a repairable fault has occurred in the battery pack; and a third threshold amount of discharge current that indicates that a minor abnormality compared to the repairable fault has occurred in the battery pack.

Meanwhile, when the battery diagnosis apparatus according to embodiments of the present disclosure is configured to be included in a BMS, the BMS may additionally include a Battery Monitoring Integrated Chip (BMIC). Here, the BMIC may be an IC-type component located inside the BMS and measuring information such as voltage, temperature, and current of a battery cell/module.

Meanwhile, the battery diagnosis apparatus 200 according to embodiments of the present disclosure may further include an input interface device 240, an output interface device 250, a storage device 260, etc. Respective components included in the battery diagnosis apparatus 200 may be connected by a bus 270 and may communicate with each other.

Additionally, the memory (or storage unit) of the battery diagnosis apparatus 200 may include at least one of a volatile storage medium and a non-volatile storage medium. For example, the memory may include at least one of read only memory (ROM) and random access memory (RAM).

According to the embodiment of the present disclosure as described above, it is possible to diagnose an abnormality caused by a short circuit in a battery cell within a short period of time without using the battery for a long period of time. Accordingly, the safety of battery pack can be enhanced through a more robust battery pack condition diagnosis.

The operations of the method according to the embodiments of the present disclosure may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that may be executed by a computer using an interpreter.

Although some aspects of the disclosure have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present disclosure has been described with reference to the exemplary embodiment of the present disclosure, but those skilled in the art may appreciate that the present disclosure may be variously corrected and changed within the range without departing from the spirit and the area of the present disclosure described in the appending claims.

## Claims

1. An apparatus for diagnosing state of a battery pack including a plurality of cells, the apparatus comprising:
at least one processor; and
a memory coupled to the at least one processor,
wherein the at least one processor is configured to
monitor whether the battery pack has entered a rest state after being fully charged;
measure a first voltage after a first time period has elapsed after entering the rest state;
measure a second voltage after a second time period has elapsed after entering the rest state;
calculate a self-discharge amount of the battery pack based on the first voltage and the second voltage; and
determine the state of the battery pack by comparing the self-discharge amount of the battery pack with a predetermined threshold amount of discharge current.

2. The apparatus of claim 1, wherein the at least one processor configured to calculate the self-discharge amount of the battery pack includes
the at least one processor configured to derive a first SOC matching the first voltage and a second SOC matching the second voltage using an state of charge (SOC)-voltage correlation; and
calculate the self-discharge amount using a difference between the first SOC and the second SOC.

3. The apparatus of claim 1, wherein the first voltage and the second voltage are obtained by measuring open circuit voltages (OCV) of the battery pack.

4. The apparatus of claim 1, wherein the at least one processor configured to determine the state of the battery pack includes
the at least one processor configured to determine that an abnormality has occurred in at least one of the plurality of battery cells if the self-discharge amount of the battery pack is greater than or equal to the predetermined threshold amount of discharge current.

5. The apparatus of claim 1, wherein whether the first time has elapsed and whether the second time has elapsed is determined by using a real time clock (RTC) inside a battery management system (BMS).

6. The apparatus of claim 1, wherein the threshold amount of discharge current is an amount of self-discharge current that occurs when an internal short circuit occurs in a battery cell and is obtained in advance through an experiment on a battery cell in which the internal short circuit occurs.

7. The apparatus of claim 6, wherein the threshold amount of discharge current includes
a first threshold amount of discharge current that indicates a situation that a permanent failure has occurred in the battery pack;
a second threshold amount of discharge current that indicates a situation that a repairable fault has occurred in the battery pack; and
a third threshold amount of discharge current that indicates a situation that a minor abnormality compared to the repairable fault has occurred in the battery pack.

8. A method for diagnosing state of a battery pack including a plurality of cells, the method comprising:
monitoring whether the battery pack has entered a rest state after being fully charged;
measuring a first voltage after a first time period has elapsed after entering the rest state;
measure a second voltage after a second time period has elapsed after entering the rest state;
calculating a self-discharge amount of the battery pack based on the first voltage and the second voltage; and
determining the state of the battery pack by comparing the self-discharge amount of the battery pack with a predetermined threshold amount of discharge current.

9. The method of claim 8, wherein the calculating the self-discharge amount of the battery pack includes:
deriving a first SOC matching the first voltage and a second SOC matching the second voltage using an state of charge (SOC)-voltage correlation; and
calculating the self-discharge amount using a difference between the first SOC and the second SOC.

10. The method of claim 8, wherein the first voltage and the second voltage are obtained by measuring open circuit voltages (OCV) of the battery pack.

11. The method of claim 8, wherein the determining the state of the battery pack includes
determining that an abnormality has occurred in at least one of the plurality of battery cells if the self-discharge amount of the battery pack is greater than or equal to the predetermined threshold amount of discharge current.

12. The method of claim 8, wherein whether the first time has elapsed and whether the second time has elapsed is determined by using a real time clock (RTC) inside a battery management system (BMS).

13. The method of claim 8, wherein the threshold amount of discharge current is an amount of self-discharge current that occurs when an internal short circuit occurs in a battery cell and is obtained in advance through an experiment on a battery cell in which the internal short circuit occurs.

14. The method of claim 13, wherein the threshold amount of discharge current includes
a first threshold amount of discharge current that indicates a situation that a permanent failure has occurred in the battery pack;
a second threshold amount of discharge current that indicates a situation that a repairable fault has occurred in the battery pack; and
a third threshold amount of discharge current that indicates a situation that a minor abnormality compared to the repairable fault has occurred in the battery pack.
